# EUROPEAN PATENT APPLICATION

(11) **EP 4 333 088 A1**
(43) Date of publication of application: **06.03.2024**
(21) Application number: 22795544.0
(22) Date of filing: 07.04.2022
(51) Int. Cl.: H01L 51/44, H01L 51/46

(54) **PHOTOELECTRIC CONVERSION ELEMENT, PHOTOELECTRIC CONVERSION MODULE HAVING SAME, PHOTOELECTRIC CONVERSION DEVICE, MOVING BODY, AND BUILDING MATERIAL**

(30) Priority: 26.04.2021 JP 2021073759; 03.02.2022 JP 2022015369
(71) Applicant: CANON KABUSHIKI KAISHA, Tokyo 146-8501 (JP)
(72) Inventor: WATANABE, Hiroyuki, Tokyo 146-8501 (JP); WATANABE, Shuntaro, Tokyo 146-8501 (JP); KAKU, Kenichi, Tokyo 146-8501 (JP); KUNO, Jumpei, Tokyo 146-8501 (JP); MARUYAMA, Akihiro, Tokyo 146-8501 (JP); IWASAKI, Shuhei, Tokyo 146-8501 (JP); MAKISUMI, Kohei, Tokyo 146-8501 (JP); YAMAMOTO, Yuna, Tokyo 146-8501 (JP)
(74) Representative: TBK
(86) International application number: PCT/JP2022/017277
(87) International publication number: WO 2022/230628

(57) **Abstract**

In order to provide a photoelectric conversion element having higher photoelectric conversion efficiency, in a photoelectric conversion element having a first electrode 7, a second electrode 3, and a photoelectric conversion layer 5 containing an organic-inorganic perovskite compound and disposed between the first electrode 7 and the second electrode 3, a particle layer 6 including phthalocyanine compound-based particles is arranged between the photoelectric conversion layer 5 and the first electrode 7.

## Description

### [Technical Field]

The present invention relates to a photoelectric conversion element, and a photoelectric conversion device, a movable body, and a building material each including the photoelectric conversion element.

### [Background Art]

In order to solve the exhaustion problem of fossil energy and the environmental problems of the earth due to the use of fossil energy, studies on renewable and clean alternative energy sources such as solar energy, wind power, water power, and the like have been actively conducted. In particular, interest in solar cells, which directly convert solar light into electrical energy, has greatly increased. Here, the solar cell means a cell that absorbs light energy from sunlight and generates a current-voltage by using a photovoltaic effect in which electrons and charges are generated.

At present, n-p diode-type silicon (Si) single crystal-based solar cells having a light energy conversion efficiency of more than 20% are widely known and actually used for photovoltaic power generation. However, these cells require high-temperature treatment processes, and the cost per unit electric power is high because the price of the material itself is high. Further, from the perspective of silicon resources, there is a problem in supply.

On the other hand, a solar cell using organic materials (hereinafter, referred to as an "organic solar cell") does not require a high-temperature process, and can be produced by a so-called roll-to-roll method using a sheet-like substrate, so that the cost can be reduced. Further improvement in power generation efficiency and durability is desired for practical use of organic solar cells.

In particular, phthalocyanine compounds have been developed as materials for practical use of organic solar cells because of their excellent light absorptivity, charge transportability, and chemical stability. For example, PTL 1 discloses employing phthalocyanine particles as a light absorber for an organic solar cell having a bulk hetero type structure to improve the photoelectric conversion efficiency. PTL 2 discloses an organic solar cell using a perovskite compound in a photoelectric conversion layer. PTL 2 discloses that the power generation efficiency is improved by dissolving an organically modified phthalocyanine compound in organic solvent and coating the solution on the photoelectric conversion layer to form a film.

### [Citation List]

### [Patent Literature]

PTL 1: Japanese Patent Application Laid-Open No. 2012-119405
PTL 2: Japanese Patent Application Laid-Open No. 2016-139805

### [Summary of Invention]

### [Technical Problem]

According to the method disclosed in PTL 1, it is necessary to dispose the charge transport material, the electron transport material, and the light absorbing material at equal distances to obtain high power generation efficiency, which is difficult to put the method to practical use. In addition, according to the method disclosed in PTL 2, the original charge transport ability cannot be exhibited because the phthalocyanine compound is formed into a film in an amorphous state, which makes difficult to obtain high photoelectric conversion efficiency.

An objective of the present invention is to provide a photoelectric conversion element having higher photoelectric conversion efficiency, and to provide a device such as a photoelectric conversion device using the above photoelectric conversion element.

### [Solution to Problem]

A first aspect of the present invention is a photoelectric conversion element comprising: a first electrode; a second electrode; a photoelectric conversion layer disposed between the first electrode and the second electrode, and containing an organic-inorganic perovskite compound; and a particle layer disposed between the photoelectric conversion layer and the first electrode, and including phthalocyanine compound-based particles.

A second aspect of the present invention is a photoelectric conversion module comprising the multiple photoelectric conversion elements according to the first aspect of the present invention.

A third aspect of the present invention is a photoelectric conversion device comprising the photoelectric conversion element according to the first aspect of the present invention and a power storage portion or an inverter connected to the photoelectric conversion element.

A fourth aspect of the present invention is a movable body comprising the photoelectric conversion element and a machine body including the photoelectric conversion element.

A fifth aspect of the present invention is a building material comprising the photoelectric conversion element according to the first aspect of the present invention, a protection member that protects the photoelectric conversion element, and a heat dissipation member.

### [Advantageous Effects of Invention]

According to the present invention, a photoelectric conversion element having higher photoelectric conversion efficiency is provided, and usage of the above photoelectric conversion element allows to provide a photoelectric conversion module, a photoelectric conversion device, a movable body, and a building material having high photoelectric conversion efficiency.

### [Brief Description of Drawings]

[FIG. 1]

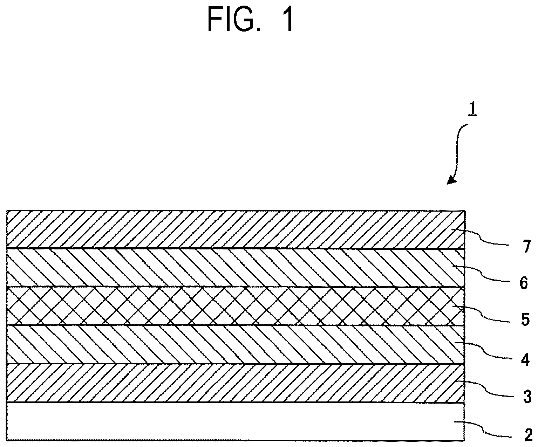

   FIG. 1 is a schematic sectional view in the thickness direction of an embodiment of the photoelectric conversion element according to the present invention.
[FIG. 2]

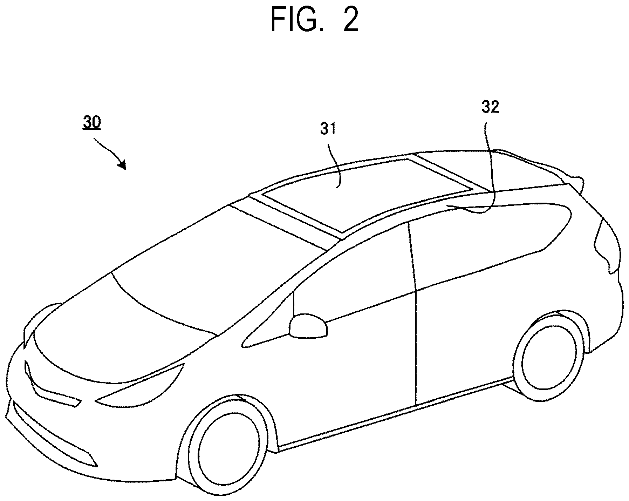

   FIG. 2 is a perspective view schematically showing an embodiment of a movable body provided with the photoelectric conversion element according to the present invention.
[FIG. 3]

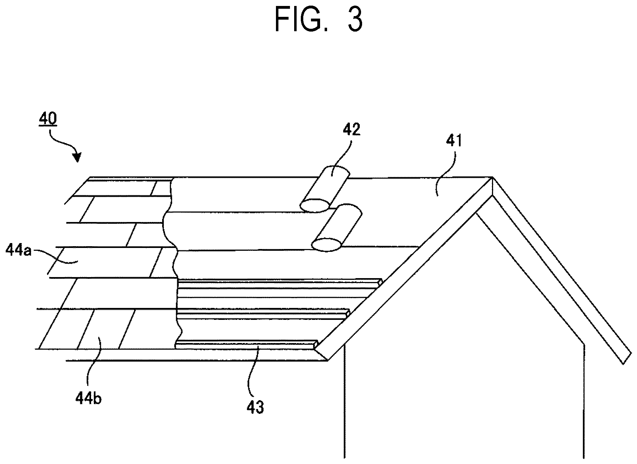

   FIG. 3 is a perspective view schematically showing an embodiment of a building material provided with the photoelectric conversion element according to the present invention.

### [Description of Embodiments]

The photoelectric conversion element of the present invention includes a first electrode, a second electrode, and a photoelectric conversion layer disposed between the first electrode and the second electrode, the photoelectric conversion layer containing an organic-inorganic perovskite compound. The present invention is characterized in that a particle layer containing phthalocyanine compound-based particles is provided between the photoelectric conversion layer and the first electrode.

The particle layer according to the present invention is formed by dispersing particles containing a phthalocyanine compound in organic solvent and applying the solution onto the photoelectric conversion layer. As a result of studies, the present inventors have found that use of the particle layer allows a photoelectric conversion element to have an excellent photoelectric conversion efficiency. The reason why the high photoelectric conversion efficiency can be obtained from the present invention is not clear in detail, but is considered as follows. When the phthalocyanine compound is formed into a film in a particle state, high crystallinity is maintained, by which the charge transport ability inherent in phthalocyanine can be exhibited. Further, in case where the photoelectric conversion layer contains the organic-inorganic perovskite compound, the concave and convex of the submicron scale is generated on the surface. It is presumed that the interface bonding is improved by filling the concave and convex with the phthalocyanine particles, which allows to obtain particularly high photoelectric conversion efficiency.

In the present specification, the term "layer" means not only a layer having a clear boundary or a flat thin film-like layer, but also a layer having a concentration gradient in which contained elements gradually change, or a layer formed with a complicated structure together with other layers. The element of the layer may be analyzed for example by using FE-TEM/EDS line spectroscopy to a cross section of the photoelectric conversion element for examining the distribution of specific elements.

Hereinafter, embodiments of the present invention will be described in detail. The present invention is not limited to the following embodiments. All modifications, improvements, and the like properly added to the following embodiments based on ordinary knowledge of a person skilled in the art without departing from the gist of the present invention are also included in the scope of the present invention.

FIG. 1 is a cross-sectional view schematically showing a configuration of an embodiment of a photoelectric conversion element according to the present invention. The photoelectric conversion element includes a second electrode 3, an electron transport layer 4, a photoelectric conversion layer 5, a particle layer 6, and a first electrode 7 formed on a substrate 2. One of the first electrode 7 and the second electrode 3 is an anode and the other is a cathode, and a current is generated in a configuration in which the first electrode 7 and the second electrode 3 are connected via an external circuit.

The photoelectric conversion layer 5 is excited by light incident through the substrate 2, the second electrode 3, and the electron transport layer 4, or the first electrode 7 and the particle layer 6, and generates electrons or holes. That is, the photoelectric conversion layer 5 generates a current between the first electrode 7 and the second electrode 3. The electron transport layer 4 is a layer disposed between the photoelectric conversion layer 5 and the two electrodes 3, 7, and may not be formed in some cases. A plurality of the electron transport layers 4 and the photoelectric conversion layers 5 may be stacked. Such a configuration can also be referred to as a tandem structure.

### (Substrate)

The photoelectric conversion element 1 of the present invention may include a substrate 2. For example, the substrate 2 may be a transparent glass substrate such as soda lime glass or alkali-free glass, a ceramic substrate, or a transparent plastic substrate. In case of taking light from the side of the first electrode 7, an opaque material can be used for the substrate 2. In case of taking light from the side of the second electrode 3, the substrate 2 is made of a transparent material.

### (Electrode)

The first and second electrodes 7, 3 are not limited to specific materials, and known materials may be used for the first and second electrodes 7, 3. For example, metals such as gold, silver, titanium, and cupper, sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, and the like can be used. Examples of the transparent conductive material include CuI, ITO (indium tin oxide), SnO₂, AZO (aluminum zinc oxide), IZO (indium zinc oxide), GZO (gallium zinc oxide), FTO (fluorine-doped tin oxide), and ATO (antimony-doped tin oxide), and conductive transparent polymers. These materials may be solely used or two or more of these materials may be used together. At least one of the first electrode 7 and the second electrode 3 on the light incident side is a transparent electrode, and the other electrode may be a transparent electrode, or may be an electrode serving as a reflective layer formed of a light reflective material, or may be a transparent electrode having a reflective layer on the side opposite to the light incident side. In case of the first electrode 7 being on the light incident side, the second electrode 3 may be a transparent electrode, and the substrate 2 may be a reflective layer. The transparent electrodes are often patterned.

### (Photoelectric conversion layer)

The photoelectric conversion layer 5 contains an organic-inorganic perovskite compound represented by a general formula R-M-X₃ (R is an organic molecule, M is a metallic atom, and X is a halogen atom or a chalcogen atom). Using the organic-inorganic perovskite compound in the photoelectric conversion layer 5 allows the solar cell to have improved photoelectric conversion efficiency.

In the above general formula, R is an organic molecule and is preferably represented by CₚNₘHₙ (p, m, and n are all positive integers). Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azet, imidazoline, carbazole, aniline, pyridine, methylcarboxyamine, ethylcarboxyamine, propylcarboxyamine, butylcarboxyamine, pentylcarboxyamine, hexylcarboxyamine, formamidinium, ions of guanidine (e.g, methylammonium (CH₃NH₃) and the like), phenethylammonium and the like. Among these, ions of methylamine, ethylamine, propylamine, butylamine, pentylamine, hexylamine, aniline, pyridine, propylcarboxyamine, butylcarboxyamine, pentylcarboxyamine, formamidinium, and guanidine, and phenethylammonium are preferable, and ions of methylamine, ethylamine, propylamine, pentylcarboxyamine, formamidinium, and guanidine are more preferable.

The above M is a metallic atom, and examples thereof include lead, tin, bismuth, zinc, titanium, antimony, nickel, iron, cobalt, silver, copper, gallium, germanium, magnesium, calcium, indium, aluminum, manganese, chromium, molybdenum and europium. Among these, lead, tin, and bismuth are preferable from the viewpoint of overlap of electron orbitals. These metallic atoms may be used alone or two or more kinds thereof may be used together.

The above X is a halogen atom or a chalcogen atom, and examples thereof include chlorine, bromine, iodine, sulfur, and selenium. These halogen atoms or chalcogen atoms may be used alone or two or more kinds thereof may be used together. Among these, a halogen atom is preferable because the organic-inorganic perovskite compound easily becomes soluble in organic solvent due to inclusion of a halogen in the structure, which allows to use an inexpensive printing method or the like. Furthermore, iodine is more preferable because the energy band gap of the organic-inorganic perovskite compound is narrowed.

The organic-inorganic perovskite compound preferably has a cubic structure in which the metal atom M is disposed at the body-center, the organic molecule R is disposed at each vertex, and the halogen or chalcogen atom X is disposed at the face-center. Although details are not clear, it is presumed that the orientation of the octahedron in the crystal lattice can be easily changed by having the above structure, which allows the organic-inorganic perovskite compound to have an increased electron mobility, which allows the photoelectric conversion element to have improved photoelectric conversion efficiency.

The organic-inorganic perovskite compound used in the present invention is preferably a crystalline semiconductor. The crystalline semiconductor means a semiconductor from which a scattering peak can be detected by measuring an X-ray scattering intensity distribution. The organic-inorganic perovskite compound being the crystalline semiconductor allows electrons in the organic-inorganic perovskite compound to have an increased mobility, which allows the photoelectric conversion element to have improved photoelectric conversion efficiency.

The photoelectric conversion layer according to the present invention preferably has a thickness from 5 to 1000 nm. In case of the thicknesses being equal to or more than 5 nm, light can be sufficiently absorbed, and in case of the thicknesses being equal to or less than 1000 nm, generated charges can be transported to the respective electrodes. The more preferable lower limit is 10 nm or more, and the more preferable upper limit is 700 nm. The further preferable lower limit is 15 nm, and the further preferable upper limit is 500 nm.

In the present invention, a maximum height Rz of the surface roughness of the photoelectric conversion layer 5 is measured as follows. First, the surface of the photoelectric conversion layer 5 is subjected to laser analysis at a pitch of 0.2 µm at a standard magnification of 150 times using a laser microscope ("VK-X200" manufactured by Keyence Corporation). The obtained laser observation image is pre-processed with cut-off values λs = 0.25 µm and λc = 0.25 mm to obtain the maximum height Rz of the roughness.

### (Particle layer)

The photoelectric conversion element 1 of the present invention includes the particle layer 6 made of phthalocyanine compound-based particles between the photoelectric conversion layer 5 and the first electrode 7. The particles preferably contain the phthalocyanine compound in an amount of 50% by mass or more, and more preferably 80% by mass or more and 99% by mass or less, in terms of elemental analysis ratio measured by ICP/MS or the like. In case of the contained phthalocyanine compound being 50% by mass or more, the stability of the particles is high, which is preferable. In case of the contained phthalocyanine compound being 80% by mass or more, the π-π stack in the particles is strengthened, which improves the charge transport ability.

The particle layer 6 preferably has a thickness from 20 to 800 nm. In case of the film thickness being 20 nm or more, the photoelectric conversion layer 5 can be sufficiently covered, which allows to smoothly perform charge transport. In case of the film thickness being 800 nm or less, charge can be favorably transported to the respective electrodes. The film thickness is more preferably from 50 to 600 nm, and still more preferably from 50 to 400 nm.

In the present invention, the preferable upper limit of an average particle diameter of the phthalocyanine compound-based particles is 300 nm, and the preferable lower limit thereof is 20 nm. In case of the average particle diameter being equal to or less than 300 nm, concave portions of the photoelectric conversion layer 5 can be filled, which allows to smoothly extract charges generated in the photoelectric conversion layer 5. In case of the average particle diameter being 20 nm or more, the interface resistance between the particles when filling the concave portions of the photoelectric conversion layer 5 can be reduced, which allows to smoothly perform the charge transport ability. The upper limit of the average particle diameter of the particles is more preferably 250 nm, the lower limit thereof is more preferably 60 nm, the upper limit is still more preferably 150 nm, and the lower limit is still more preferably 70 nm.

An average diameter of the particles containing phthalocyanine compound as a main component may be obtained by using, for example, a dynamic light scattering method, a laser diffraction method, a gravity sedimentation method, an ultrasonic attenuation method, an image imaging method, or the like as long as the primary diameter of crystalline particles of the phthalocyanine compound can be measured. In the examples of the present invention, it is derived by using the image imaging method using a scanning electron microscope (SEM). Specifically, first, an SEM image of the particle layer 6 at a magnification of 100,000 times is used to extract crystalline particles (10,000 or more) using image processing software Photoshop (manufactured by Adobe Inc.). Then, areas S of the respective crystalline particles are determined, and diameters of circles having the same areas as the determined areas (= 2 × (S/π)^{1/2}) are defined as the average particle diameter.

In the present invention, the particles containing a phthalocyanine compound as a main component preferably include crystalline particles of a crystalline phthalocyanine compound having peaks at Bragg angles 2θ of 7.4° ± 0.3° and 28.2° ± 0.3° in an X-ray diffraction spectrum using CuK α-ray. Further, the particles preferably include crystalline particles of a phthalocyanine compound having a peak from 20 to 50 nm in a crystalline particle size distribution measured using small-angle X-ray scattering, and having a half-width of the peak being 50 nm or less.

The powder X-ray diffraction measurement of the phthalocyanine compound-based particles was performed under the following conditions.

### [Powder X-ray diffraction measurement]

Measurement equipment used: X-ray diffraction device "RINT-TTRII" manufactured by Rigaku Corporation
X-ray tube: Cu
X-ray wavelength: Kα1
Tube voltage: 50KV
Tube current: 300 mA
Scan method: 2θ scan
Scan speed: 4.0°/min
Sampling interval: 0.02°
Start angle 2θ: 5.0°
Stop angle 2θ: 35.0°
Goniometer: Rotor horizontal goniometer (TTR-2)
Attachment: Capillary rotary sample stage
Filter: None
Detector: Scintillation counter
Incident monochrome: Used
Slit: Variable slit (parallel beam method)
Counter monochromator: Not used
Divergence slit: Open
Divergent longitudinal limiting slit: 10.00mm
Scattering slit: Open
Light reception slit: Open

In the present invention, the phthalocyanine compound may include a metal ligand. Examples of the coordinating metal include Ga, Cu, and Ti. Among these, Ga is preferable from a viewpoint of crystallinity. The coordinating metal may include a substituent. Examples of the substituent include a hydroxy group and a halogen group. Among these, the hydroxy group is preferable from a viewpoint of charge transport ability. From these viewpoints, the particularly preferable phthalocyanine compound is hydroxygallium phthalocyanine.

In the photoelectric conversion element of the present invention, an electron transport layer may be disposed between the first electrode 7 and the photoelectric conversion layer 5 and/or between the second electrode 3 and the photoelectric conversion layer 5. The photoelectric conversion element 1 shown in FIG. 1 is an example in which the electron transport layer 4 is disposed between the second electrode 3 and the photoelectric conversion layer 5.

The electron transport layer 4 is not limited to specific materials, and materials of the electron transport layer 4 may be, for example, N-type conductive polymer, N-type low molecular organic semiconductor, N-type metal oxide, N-type metal sulfide, alkali metal halide, alkali metal, surfactants and the like, specifically for example, cyano group-containing polyphenylene vinylene, boron-containing polymer, bathocuproine, bathophenanthrene, hydroxyquinolinato aluminum, oxadiazole compound, benzimidazole compound, naphthalenetetracarboxylic acid compound, perylene derivative, phosphine oxide compound, phosphine sulfide compound, fluoro group-containing phthalocyanine, titanium oxide, zinc oxide, indium oxide, tin oxide, gallium oxide, tin sulfide, indium sulfide, zinc sulfide and the like.

The electron transport layer 4 may be formed of only a thin-film electron transport layer, but preferably includes a porous electron transport layer. In particular, in the case where the photoelectric conversion layer 5 is a composite film containing an organic-inorganic perovskite compound, a more complex composite film (more complex structure) is obtained, and the photoelectric conversion efficiency is increased. Therefore, the photoelectric conversion layer 5 of the composite film is preferably formed on the porous electron transport layer 4.

The lower limit of the thickness of the electron transport layer 4 is preferably 1 nm, and the upper limit thereof is preferably 2000 nm. In case of the film thickness being equal to or more than the 1 nm, holes can be sufficiently blocked, and in case of the film thickness being equal to or less than the 2000 nm, the film is less likely to be a resistance in transporting electrons, which allows to increase the photoelectric conversion efficiency. A more preferable lower limit is 3 nm and a more preferable upper limit is 1000 nm, and a still more preferable lower limit is 5 nm and a still more preferable upper limit is 500 nm.

### (Photoelectric conversion device)

The photoelectric conversion device of the present invention includes multiple photoelectric conversion elements according to the present invention, and in the case where the multiple photoelectric conversion elements are connected, it can also be referred to as a photoelectric conversion module. The photoelectric conversion elements may be stacked to increase an output voltage. The photoelectric conversion device includes the photoelectric conversion element of the present invention and an inverter. The inverter may be a converter that converts direct current to alternating current. The photoelectric conversion device may include a power storage portion connected to the photoelectric conversion element. The power storage portion is not limited to particular devices as long as it can store electricity. Examples thereof include a secondary battery using lithium ions or the like, an all-solid-state battery, and an electric double layer capacitor.

### (Movable body)

FIG. 2 is a perspective view schematically showing an embodiment of a movable body including the photoelectric conversion element according to the present invention. A movable body 30 includes a photoelectric conversion element 31 of the present invention and a machine body 32 including the photoelectric conversion element 31. The photoelectric conversion element 31 is disposed at a position in the machine body 32 where external light can be received. If the movable body 30 is an automobile, it may be disposed on the roof. The electric energy obtained by the photoelectric conversion element 31 may serve as power of the movable body 30 or power of other electric devices. Electric energy generated from the power of the movable body 30 may be used as the power for the photoelectric conversion element 31. In case of the movable body 30 being an automobile, frictional energy generated by braking may be converted into electric energy and used to control the photoelectric conversion element 31.

The movable body 30 may be, for example, an automobile, a ship, an aircraft, or a drone. The machine body 32 of the movable body 30 is not limited to particular configurations, but the machine body 32 is preferably made of materials having high strength.

### (Building material)

FIG. 3 is a perspective view schematically showing an embodiment of a building material provided with the photoelectric conversion element of the present invention. A building material 40 may be a roof of a building. The building material 40 of the present embodiment includes a photoelectric conversion element 41 of the present invention, a protection member 42 for protecting the photoelectric conversion element 41, a heat dissipation member 43, and exteriors 44a, 44b.

The building material 40 of the present invention may have a heat dissipation member 43 having a higher thermal conductivity than the photoelectric conversion element 41. In case that the photoelectric conversion element 41 is used for a roof or the like, the temperature of the photoelectric conversion element 41 may increase due to sunlight, which may result in decreasing the photoelectric conversion efficiency. Using the heat dissipation member 43 allows to suppress a decrease in the photoelectric conversion efficiency. Examples of the heat dissipation member 43 include a metal, an alloy, a liquid metal, and a liquid resin.

Further, the building material 40 of the present invention may include the exteriors 44a, 44b. The exterior 44a and the exterior 44b may emit different colors or may emit the same color. The exteriors 44a, 44b may be formed of the same members or may be formed of different members. As the exteriors, a paint or a transparent substrate may be used. Those having low light absorption and high heat shielding properties are preferred.

### [Example]

Hereinafter, the present invention will be described in more detail with reference to examples, but the present invention is not limited to these examples. In addition, "parts" in the following description represent "parts by mass" unless otherwise specified.

### [Preparation of phthalocyanine compound-based particles]

### <Manufacture of particles 1>

### Step (1)

Under an atmosphere of nitrogen flow, 5.46 parts of orthophthalonitrile and 45 parts of α-chloronaphthalene were charged into a reaction vessel, and then heated to a temperature of 30 °C, and this temperature was maintained. Then, 3.75 parts of gallium trichloride was charged at this temperature (30 °C). The water concentration of the mixed solution at time of the charging was 150 ppm. Then, the temperature was raised to 200 °C. Next, the mixture was reacted at a temperature of 200 °C for 4.5 hours under an atmosphere of nitrogen flow, then cooled, and when the temperature reached 150 °C, the product was filtered. The obtained filtrate was dispersed and washed with N,N-dimethylformamide at a temperature of 140 °C for 2 hours, and then filtered. The obtained filtrate was washed with methanol and then dried to obtain chlorogallium phthalocyanine particles in a yield of 71%.

### Step (2)

The chlorogallium phthalocyanine particles (4.65 parts) were dissolved in concentrated sulfuric acid (139.5 parts) at a temperature of 10 °C, and the solution was added dropwise to ice water (620 parts) with stirring for reprecipitation, followed by filtration under reduced pressure using a filter press. At this time, No. 5C (manufactured by Advantec Co., Ltd) was used as a filter. The obtained wet cake (filtrate) was dispersed and washed with 2% ammonia water for 30 minutes, and then filtered using a filter press. Then, the obtained wet cake (filtrate) was dispersed and washed with ion-exchanged water, and then filtration using a filter press was repeated three times. Finally, freeze-drying (lyophilization) is performed to obtain hydroxygallium phthalocyanine particles (hydrous hydroxygallium phthalocyanine particles) having a solid content of 23% by mass in a yield of 71%. The hydroxygallium phthalocyanine particles were dried with a Hyper-Dry dryer (product name: HD-06R, frequencies (oscillation frequencies): 2455 MHz ± 15 MHz, manufactured by Nippon Biocon Co., Ltd) to obtain hydroxygallium phthalocyanine particles (crystals) having a water content of 1.0% by mass or less.

### Step (3)

Five parts of the hydroxygallium phthalocyanine particles were subjected to a dispersion treatment for 6 hours using a sand mill (K-800, manufactured by Igarashi Mechanical Manufacturing (Currently Imex Co., Ltd.), disc size: 70 mm, number of discs: five) filled with five parts of DMF solvant and five parts of glass beads, followed by filtration and drying to obtain particles 1.

Further, by changing the dispersion time and the amount of glass beads in the step (3), particles 2 to 16 shown in Table 1 having different particle diameters and different crystallinities were produced. In Table 1, "Pc compound" means a phthalocyanine compound.

**[Table 1]**

| Particles | Particle diameters /nm | XRD peak | | Small angle X ray scattering | | Elemental analysis ratio of Pc compound |
|---|---|---|---|---|---|---|
| | | 7.4°±0.3° | 28.2°±0.3° | crystallite size peak | crystallite size peak half width | |
| Particles 1 | 70 | 7.4 | 28.2 | 30 | 30 | 90 |
| Particles 2 | 70 | 7.9 | 28.9 | 50 | 70 | 90 |
| Particles 3 | 250 | 8 | 29 | 70 | 70 | 90 |
| Particles 4 | 300 | 8.3 | 29.3 | 80 | 80 | 90 |
| Particles 5 | 20 | 7 | 27.7 | 15 | 40 | 90 |
| Particles 6 | 300 | 7.4 | 28.2 | 70 | 90 | 90 |
| Particles 7 | 270 | 7 | 27.7 | 40 | 40 | 90 |
| Particles 8 | 200 | 8 | 29 | 70 | 70 | 90 |
| Particles 9 | 150 | 7.9 | 28.9 | 50 | 70 | 90 |
| Particles 10 | 260 | 7 | 27.7 | 60 | 80 | 90 |
| Particles 11 | 170 | 7.4 | 28.2 | 30 | 30 | 50 |
| Particles 12 | 150 | 7.4 | 28.2 | 30 | 30 | 60 |
| Particles 13 | 100 | 7.4 | 28.2 | 30 | 30 | 75 |
| Particles 14 | 90 | 7.4 | 28.2 | 30 | 30 | 79 |
| Particles 15 | 80 | 7.4 | 28.2 | 30 | 30 | 80 |

### (Example 1)

### [Cleaning of substrate and second electrode]

A glass substrate with ITO (manufactured by Geomatec Co., Ltd.) was subjected to ultrasonic cleaning using pure water, acetone, and methanol in the above order for 10 minutes each, and then dried. Then, the glass substrate with ITO was subjected to a UV ozone treatment for 20 minutes.

### [Formation of electron transport layer]

A titanium isopropoxide ethanol solution adjusted to 2% by mass was coated on the glass substrate with ITO using a spin coating method, and baked at 400 °C for 10 minutes to form a thin electron transport layer having a thickness of 20 nm. Further, a titanium oxide paste containing polyisobutyl methacrylate as an organic binder, titanium oxide (average particle diameter: 25 nm) and ethanol was coated on the thin-film electron transport layer by a spin coating method, and baked at 500 °C for 10 minutes to form a porous electron transport layer having a thickness of 500 nm.

### [Formation of photoelectric conversion layer]

4 gram of Lead iodide and 1.4 gram of methylammonium iodide were dissolved in 4.5 gram of dimethylformamide, and the mixture was stirred at 60 °C for 24 hours to prepare a coating solution for a photoelectric conversion layer. The coating solution was spin-coated on the electron transport layer to form a photoelectric conversion layer having a thickness of 500 nm. At this time, the maximum height Rz of the surface roughness of the photoelectric conversion layer was 270 nm.

### [Formation of particle layer]

5 g of the particles 1 in Table 1, 45 g of chlorobenzene, and 50 g of glass beads were sealed in a glass bottle, and the mixture was dispersed for 6 hours using a paint shaker to prepare a particle-layer coating liquid. The photoelectric conversion layer was spin-coated with the particle-layer coating liquid to form a particle layer composed only of the particles having a thickness of 100 nm.

### [Introduction of charge transport material into Particle Layer]

Spiro-OMeTAD (180 mg) as a charge transport material was dissolved in chlorobenzene (1 mL). To the chlorobenzene solution, an acetonitrile liquid (37.5 µL) in which lithium-bis (trifluoromethanesulfonyl) imide (170 mg) was dissolved in acetonitrile (1 mL) and t-butylpyridine (TBP, 17.5 µL) were added and mixed to prepare a charge transport material liquid. This liquid was applied by spin coating onto the particles layer formed of only the particles to form a particle layer having a total thickness of 200 nm in which the particles were covered with the charge transport material.

### [Formation of First Electrode]

Gold electrodes having a thickness of 80 nm and an areal size of 0.09 cm² were formed on the particle layer by a vacuum vapor deposition method to obtain a photoelectric conversion element.

### (Example 2)

A photoelectric conversion element was obtained in the same manner as in Example 1, except that the particles 4 were used as the phthalocyanine compound-based particles, and a particle layer having a thickness of 700 nm was formed using only the particles without using a charge transport material.

### (Example 3)

A photoelectric conversion element was obtained in the same manner as in Example 2 except that the particles 10 were used as the phthalocyanine compound-based particles.

### (Example 4)

A photoelectric conversion element was obtained in the same manner as in Example 3 except that the maximum height Rz of the surface roughness of the photoelectric conversion layer was 190 nm.

### (Example 5)

A photoelectric conversion element was obtained in the same manner as in Example 3 except that the maximum height Rz of the surface roughness of the photoelectric conversion layer was 300 nm.

### (Example 6)

A photoelectric conversion element was obtained in the same manner as in Example 2 except that the particles 3 were used as the phthalocyanine compound-based particles.

### (Example 7)

A photoelectric conversion element was obtained in the same manner as in Example 2 except that the particles 9 were used as the phthalocyanine compound-based particles.

### (Example 8)

A photoelectric conversion element was obtained in the same manner as in Example 2 except that the particles 8 were used as the phthalocyanine compound-based particles.

### (Example 9)

A photoelectric conversion element was obtained in the same manner as in Example 2 except that the particles 2 were used as the phthalocyanine compound-based particles.

### (Example 10)

A photoelectric conversion element was obtained in the same manner as in Example 2 except that the particles 5 were used as the phthalocyanine compound-based particles.

### (Example 11)

A photoelectric conversion element was obtained in the same manner as in Example 2 except that a particle layer containing only the particles was formed in the same manner as in Example 1, and then the particle layer was formed by introducing a charge transport material. The particle layer was formed to have a total thickness 100 nm greater than a thickness of the particles alone.

### (Example 12)

A photoelectric conversion element was obtained in the same manner as in Example 2 except that the particle layer has a thickness of 500 nm.

### (Example 13)

A photoelectric conversion element was obtained in the same manner as in Example 2 except that the particle layer had a thickness of 40 nm, and the particles 5 were used as the phthalocyanine compound-based particles.

### (Example 14)

A photoelectric conversion element was obtained in the same manner as in Example 2 except that the particles 6 were used as the phthalocyanine compound-based particles.

### (Example 15)

A photoelectric conversion element was obtained in the same manner as in Example 2 except that the particles 7 were used as the phthalocyanine compound-based particles.

### (Example 16)

A photoelectric conversion element was obtained in the same manner as in Example 2 except that the particle layer had a thickness of 400 nm.

### (Example 17)

A photoelectric conversion element was obtained in the same manner as in Example 9 except that a particle layer containing only the particles was formed in the same manner as in Example 1, and then the particle layer was formed by introducing a charge transport material. The particle layer was formed to have a total thickness 100 nm greater than a thickness of the particles alone.

### (Example 18)

A photoelectric conversion element was obtained in the same manner as in Example 9 except that the particle layer had a thickness of 200 nm.

### (Example 19)

A photoelectric conversion element was obtained in the same manner as in Example 18 except that a particle layer containing only the particles was formed in the same manner as in Example 1, and then the particle layer was formed by introducing a charge transport material. The particle layer was formed to have a total thickness 100 nm greater than a thickness of the particles alone.

### (Example 20)

### [Cleaning of substrate]

The glass substrate was subjected to ultrasonic cleaning using pure water, acetone, and methanol in the above order for 10 minutes each, and then dried.

### [Formation of second electrode]

An Al electrode having a thickness of 1000 nm was formed on the glass substrates by a vacuum vapor deposition method.

### [Formation of electron transport layer]

A tin oxide-dispersed aqueous colloidal solution (manufactured by Alfa Aesar) was spin-coated on the Al electrode and dried at 150 °C for 30 minutes to form an electron transport layer having a thickness of 50 nm.

### [Formation of photoelectric conversion layer and particle layer]

The processes were conducted in the same manners as in Example 1.

### [Formation of First Electrode]

An ITO electrode having a thickness of 150 nm and an area of 0.09 cm² was formed on the particle layer by a sputtering method using an ITO target doped with 5% by mass of tin and using Ar gas containing O₂ (5 mol %) under a condition of a pressure of 0.5 Pa.

### (Example 21)

A photoelectric conversion element was obtained in the same manner as in Example 1 except that the particles 11 were used as the phthalocyanine compound-based particles.

### (Example 22)

A photoelectric conversion element was obtained in the same manner as in Example 1 except that the particles 12 were used as the phthalocyanine compound-based particles.

### (Example 23)

A photoelectric conversion element was obtained in the same manner as in Example 1 except that the particles 13 were used as the phthalocyanine compound-based particles.

### (Example 24)

A photoelectric conversion element was obtained in the same manner as in Example 1 except that the particles 14 were used as the phthalocyanine compound-based particles.

### (Example 25)

A photoelectric conversion element was obtained in the same manner as in Example 1 except that the particles 15 were used as the phthalocyanine compound-based particles.

### (Example 26)

A photoelectric conversion element was obtained in the same manner as in Example 1 except that the particles 16 were used as the phthalocyanine compound-based particles.

### (Comparative example 1)

### [Cleaning of substrate and second electrode]

The processes were conducted in the same manners as in Example 1.

### [Formation of injection layer]

An LiF film having a thickness of 0.5 nm was formed on the second electrode by a vacuum vapor deposition method.

### [Formation of bulk hetero layer]

A coating liquid for a bulk hetero layer was prepared by dissolving and dispersing 1 g of poly (3-hexylthiophene), 1 g of fullerene derivative (PCBM: Phenyl-C61-Butyric-Acid-Methyl Ester), and 8 g of the particles 1 and 15 g of chlorobenzene. The coating liquid was spin-coated on the injection layer to form a bulk hetero layer having a thickness of 300 nm.

### [Formation of first electrode]

The processes were conducted in the same manners as in Example 1.

### (Comparative example 2)

### [Cleaning of substrate]

The titanium substrate was subjected to ultrasonic cleaning using pure water, acetone, and methanol in the above order for 10 minutes each, and then dried.

### [Formation of second electrode]

The processes were conducted in the same manners as in Example 20.

### [Formation of electron transport layer and photoelectric conversion layer]

The processes were conducted in the same manners as in Example 1.

### [Formation of charge transport layer]

A coating liquid for a charge transport layer was prepared by dissolving 1 g of Phthalocyanine (purified by sublimation) [for organic electronics] (manufactured by TCI) in 9 g of chlorobenzene. The coating liquid was spin-coated on the photoelectric conversion layer to form a charge transport layer having a thickness of 100 nm.

### [Formation of First Electrode]

The processes were conducted in the same manners as in Example 20.

### <Evaluation>

The photoelectric conversion elements obtained in the respective Examples and Comparative examples were evaluated as follows.

### (Evaluation of power generation efficiency)

A power source (236 model, manufactured by Keithley Instruments Inc.) was connected between the electrodes of the photoelectric conversion element, constant light was irradiated using a solar simulator (manufactured by Yamashita Denso Co., Ltd.) having an intensity of 100 mW/cm², and current and voltage generated were measured to evaluate photoelectric conversion efficiency. The results are shown in Table 2.

**[Table 2]**

| | Surface roughness of photoelectric conversion layer: maximum height Rz [nm] | Particle No. | Charge transport material | Thickness of particle layer [nm] | Photoelectric conversion efficiency [%] |
|---|---|---|---|---|---|
| Example 1 | 270 | 1 | Included | 200 | 19.0 |
| Example 2 | 270 | 4 | Not included | 700 | 10.2 |
| Example 3 | 270 | 10 | Not included | 700 | 11.8 |
| Example 4 | 190 | 10 | Not included | 700 | 10.5 |
| Example 5 | 300 | 10 | Not included | 700 | 11.5 |
| Example 6 | 270 | 3 | Not included | 700 | 12.6 |
| Example 7 | 270 | 9 | Not included | 700 | 13.4 |
| Example 8 | 270 | 8 | Not included | 700 | 12.7 |
| Example 9 | 270 | 2 | Not included | 700 | 13.8 |
| Example 10 | 270 | 5 | Not included | 700 | 11.0 |
| Example 11 | 270 | 4 | Included | 700 | 12.2 |
| Example 12 | 270 | 4 | Not included | 500 | 13.1 |
| Example 13 | 270 | 5 | Not included | 40 | 11.0 |
| Example 14 | 270 | 6 | Not included | 700 | 13.5 |
| Example 15 | 270 | 7 | Not included | 700 | 13.8 |
| Example 16 | 270 | 4 | Not included | 400 | 13.5 |
| Example 17 | 270 | 2 | Included | 700 | 16.1 |
| Example 18 | 270 | 2 | Not included | 200 | 17.2 |
| Example 19 | 270 | 2 | Included | 200 | 18.0 |
| Example 20 | 270 | 1 | Included | 200 | 16.5 |
| Example 21 | 270 | 11 | Included | 200 | 170 |
| Example 22 | 270 | 12 | Included | 200 | 17.1 |
| Example 23 | 270 | 13 | Included | 200 | 17.1 |
| Example 24 | 270 | 14 | Included | 200 | 17.1 |
| Example 25 | 270 | 15 | Included | 200 | 18.0 |
| Example 26 | 270 | 16 | Included | 200 | 19.3 |
| Comparative Example 1 | - | 1 | Included | - | 4.8 |
| Comparative Example 2 | 270 | - | Included | - | 7.9 |

The present invention is not limited to the above-described embodiments, and various changes and modifications can be made without departing from the spirit and scope of the present invention. Accordingly, the following claims are appended to disclose the scope of the invention.

This application claims the benefit of priority based upon Japanese Patent Application No. 2021-073759 filed on April 26, 2021 and Japanese Patent Application No. 2022-015369 filed on February 3, 2022, the disclosures of which are hereby incorporated by reference herein in their entirety.

### [Reference Signs List]

1, 31, and 41: photoelectric conversion element, 2: substrate, 3: second electrode, 5: photoelectric conversion layer, 6: particle layer, 7: first electrode, 30: movable body, 32: machine body, 40: building material, 42: protection member, and 43: heat dissipation member

## Claims

1. A photoelectric conversion element comprising:
a first electrode;
a second electrode;
a photoelectric conversion layer disposed between the first electrode and the second electrode, and containing an organic-inorganic perovskite compound; and
a particle layer disposed between the photoelectric conversion layer and the first electrode, and including phthalocyanine compound-based particles.

2. The photoelectric conversion element according to claim 1, wherein an average particle diameter of the particles is smaller than the maximum height Rz of the surface roughness of the photoelectric conversion layer.

3. The photoelectric conversion element according to claim 1 or 2, wherein an average particle diameter of the particles is 300 nm or less.

4. The photoelectric conversion element according to any one of claims 1 to 3, wherein an average particle diameter of the particles is 20 nm or more.

5. The photoelectric conversion element according to any one of claims 1 to 4, wherein the particle layer includes the particles and a charge transport material.

6. The photoelectric conversion element according to any one of claims 1 to 5, wherein the particle layer has a thickness from 20 to 800 nm.

7. The photoelectric conversion element according to any one of claims 1 to 5, wherein the particle layer has a thickness from 50 to 400 nm.

8. The photoelectric conversion element according to any one of claims 1 to 7, wherein the particles include crystalline particles of a crystalline phthalocyanine compound exhibiting peaks at 7.4°±0.3° and 28.2°±0.3° of Bragg angles 2θ in an X-ray diffraction spectrum using CuKα ray.

9. The photoelectric conversion element according to any one of claims 1 to 8, wherein the particles include crystalline particles of a phthalocyanine compound having a peak from 20 to 50 nm in a crystalline particle size distribution measured using small-angle X-ray scattering, and a half width of the peak is 50 nm or less.

10. The photoelectric conversion element according to any one of claims 1 to 9, wherein the particles contain a phthalocyanine compound in a range of 80% to 99% by mass in an elemental analysis ratio.

11. A photoelectric conversion module comprising a plurality of the photoelectric conversion elements according to any one of claims 1 to 10.

12. A photoelectric conversion device comprising:
the photoelectric conversion element according to any one of claims 1 to 10; and
a power storage portion connected to the photoelectric conversion element.

13. A photoelectric conversion device comprising:
the photoelectric conversion element according to any one of claims 1 to 10; and
an inverter connected to the photoelectric conversion element.

14. A movable body comprising:
the photoelectric conversion element according to any one of claims 1 to 10; and
a machine body including the photoelectric conversion element.

15. A building material comprising:
the photoelectric conversion element according to any one of claims 1 to 10;
a protection member that protects the photoelectric conversion element; and
a heat dissipation member.
